(19) Europäisches Patentamt
European Patent Office
Office européen des brevets

(11) EP 1 516 901 A1

(12) EUROPEAN PATENT APPLICATION
published in accordance with Art. 158(3) EPC

(43) Date of publication:
**23.03.2005 Bulletin 2005/12**

(21) Application number: **03736256.3**

(22) Date of filing: **26.06.2003**

(51) Int Cl.[7]: **C09K 11/06**, C08F 30/04, H05B 33/14, H05B 33/10

(86) International application number:
**PCT/JP2003/008109**

(87) International publication number:
**WO 2004/003105 (08.01.2004 Gazette 2004/02)**

(84) Designated Contracting States:
**AT BE BG CH CY CZ DE DK EE ES FI FR GB GR HU IE IT LI LU MC NL PT RO SE SI SK TR**

(30) Priority: **27.06.2002 JP 2002187719**

(71) Applicant: **JSR Corporation**
**Tokyo 104-0045 (JP)**

(72) Inventors:
- **SAKAKIBARA, Mitsuhiko c/o JSR Corporation**
  **Chuo-ku, Tokyo 104-0045 (JP)**
- **YASUDA, Hiroyuki c/o JSR Corporation**
  **Chuo-ku, Tokyo 104-0045 (JP)**
- **ERIYAMA, Yuichi c/o JSR Corporation**
  **Chuo-ku, Tokyo 104-0045 (JP)**

(74) Representative:
**Leson, Thomas Johannes Alois, Dipl.-Ing. et al**
**Patentanwälte**
**Tiedtke-Bühling-Kinne & Partner,**
**Bavariaring 4**
**80336 München (DE)**

# (54) PHOSPHORS AND PROCESS FOR PRODUCTION THEREOF, LUMINESCENT COMPOSITIONS, AND ORGANIC ELECTROLUMINESCENT DEVICES AND PROCESSES FOR PRODUCTION THEREOF

(57) Disclosed herein are, a phosphorescent agent which can form a thin film by a wet method and provide an organic electroluminescence device having high luminance and production process thereof, and a luminescent composition containing the phosphorescent agent, an organic electroluminescence device having a luminescent layer containing the phosphorescent agent and production process thereof.

A phosphorescent agent according to the present invention comprising a polymer having in its molecule a structural unit represented by the following general formula (1).

General formula (1)

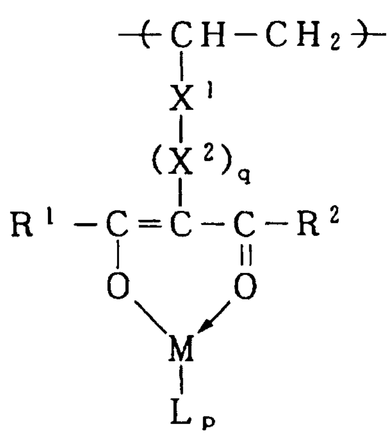

[In the general formula (1), M represents a metal atom having a valence of 2 to 4, each of $R^1$ and $R^2$ represents a hydrogen atom, a halogen atom, a cycloalkyl group, an aryl group and a heterocycle group and $R^1$ and $R^2$ may be either the same or different, $X^1$ represents a phenylene group or a carbonyloxy group, $X^2$ represents an alkylene group, L represents an organic ligand, p is an integer of 1 to 3, and q is 0 or 1.]

EP 1 516 901 A1

Printed by Jouve, 75001 PARIS (FR)

## Description

### TECHNICAL FIELD

The present invention relates to a phosphorescent agent suitably usable as a material for an organic electroluminescence device, and a production process thereof, a luminescent composition containing the phosphorescent agent, and an organic electroluminescence device having a luminescent layer containing the phosphorescent agent and the production process thereof.

### BACKGROUND ART

An organic electroluminescence device is expected to be a display device of the coming generation because it has such excellent properties as can be formed into a thin structure, driven by direct current voltage or alternating current voltage, is wide in angle of visibility and high in visibility because it is a self-luminescent device and fast in speed of response, and the researches thereof are being actively conducted.
As such organic electroluminescence devices, there have heretofore been known those of a single-layer structure in which a luminescent layer composed of an organic material is formed between an anode and a cathode, and those of a multilayer structures such as those of a structure having a hole-transporting layer between an anode and a luminescent layer and those of a structure having an electron-transporting layer between a cathode and a luminescent layer. These organic electroluminescence devices all emit light by recombination of electrons injected from the cathode with holes injected from the anode occurring at the luminescent layer.
As methods for forming an organic material layer in such an organic electroluminescence device, such as the luminescent layer or the hole-transporting layer, there have been known a dry method in which the organic material layer is formed by vacuum deposition of an organic material and a wet method in which a solution of an organic material dissolved therein is applied and dried to form a layer. Among these, the dry method is difficult to meet mass production because the process is complicated, and there is a limit to the formation of a layer having a large area. On the contrary, the wet method is advantageous compared with the dry method in that the process is relatively simple, and so the method can meet mass production, and an organic material layer having a large area can be formed with ease and high precision by using an ink-jet method, for example.
On the other hand, the organic material layer making up the organic electroluminescence device is required to have a high luminance. As the organic material layer, those composed of various materials have heretofore been known, and an organic material layer containing a phosphorescent organoiridium compound or organoosmium compound as a luminous molecule has recently been proposed (Refer to pamphlet of WO 00/70655). The organic material layer is composed of a low molecular organoiridium compound or organoosmium compound alone or of such a compound with a hole-transporting material such as 4,4'-N,N'-dicarbazole biphenyl or 4,4'-bis[N-(1-naphthyl)-N-phenylamino]biphenyl.
Further, a luminescent material composed of a low-molecular iridium compound, polyvinylcarbazole and oxadiazole has been proposed in MRS 2000 Fall Meeting (November 27 to December 1, 2000, Boston, Massachusetts, USA).
However, it is difficult to obtain a luminescent layer satisfying sufficient performance in luminance when the luminescent layer is formed using the above material by a wet method such as an ink-jet method.

### DISCLOSURE OF THE INVENTION

The present invention has been made on the basis of the foregoing circumstances and the first object thereof is to provide a phosphorescent agent with which a thin film can be formed by a wet method such as printing method or ink-jet method, and an organic electroluminescence device having high luminance can be provided.
The second object of the present invention is to provide a method by which the phosphorescent agent as above is produced advantageously.
The third object of the present invention is to provide a luminescent composition by which a thin film can be formed easily and an organic electroluminescence device having high luminance can be provided.
The fourth object of the present invention is to provide an organic electroluminescence device having a luminescent layer that can be formed with ease by a wet method such as printing method or ink-jet method, and having high luminance.
The fifth object of the present invention is to provide a process for producing an organic electroluminescence device by which a luminescent layer can be formed easily by a wet method such as printing method or ink-jet method and having high luminance.
According to the present invention, there is provided a phosphorescent agent comprising a polymer having

in its molecule a structural unit represented by the following general formula (1).

General formula (1)

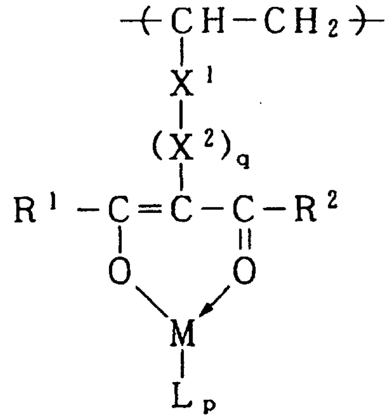

[In the general formula (1), M represents a metal atom having a valence of 2 to 4, each of $R^1$ and $R^2$ represents a hydrogen atom, a halogen atom or a monovalent organic group selected from an alkyl group, a cycloalkyl group, an aryl group and a heterocycle group and $R^1$ and $R^2$ may be either the same or different, $X^1$ represents a phenylene group or a oxycarbonyl group, $X^2$ represents an alkylene group, L represents an organic ligand, p is an integer of 1 to 3, and q is 0 or 1.]

The phosphorescent agent according to the present invention may preferably contain a structural unit derived from a hole-transporting monomer in the molecule of the polymer, and moreover, the polymer may preferably have a structural unit derived from an electron-transporting monomer in the molecule of the polymer.

In such a phosphorescent agent, it is preferable that the hole-transporting monomer is carbazole compound having a vinyl group, and it also is preferable that the hole-transporting monomer is carbazole compound having a vinyl group and the electron-transporting monomer is an oxadiazole compound having a vinyl group.

According to the present invention, there is provided a production process of a phosphorescent agent comprising the step of synthesizing a polymer having in its molecule the structural unit represented by the above general formula (1), by reacting a polymer having in its molecule a structural unit represented by the following general formula (2) with an organic metal complex.

General formula (2)

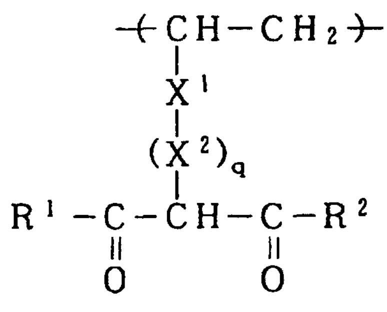

[In the general formula (2), each of $R^1$ and $R^2$ represents a hydrogen atom, a halogen atom or a monovalent organic group selected from an alkyl group, a cycloalkyl group, an aryl group and a heterocycle group, and $R^1$ and $R^2$ may be either the same or different, $X^1$ represents a phenylene group or a oxycarbonyl group, $X^2$ represents an alkylene group, and q is 0 or 1.]

According to the present invention, there is provided a luminescent composition comprising the above-mentioned phosphorescent agent dissolved in an organic solvent.

According to the present invention, there is provided an organic electroluminescence device having a luminescent layer containing the above-mentioned phosphorescent agent.

According to the present invention, there is provided a production process of the organic electroluminescence device comprising the steps of; applying the above-mentioned luminescent composition on a surface of a substrate on which a luminescent layer is to be formed, and conducting removal treatment for removing an organic solvent to the resultant coated film to form a luminescent layer.

BRIEF DESCRIPTION OF THE DRAWINGS

FIG.1 is a cross sectional view for explanation showing a structure in an example of an organic electroluminescence device having a luminescent layer formed with a luminescent composition according to the present invention.
FIG.2 is a cross sectional view for explanation showing a structure in another example of an organic electroluminescence device having a luminescent layer formed with a luminescent composition according to the present invention.

[Description of Characters]

1 Transparent substrate
2 Anode layer
3 Hole-transporting layer
4 Copper-phthalocyanine layer
5 Luminescent layer
6 Electron-injecting layer
7 Cathode layer
8 Direct current power source

BEST MODE FOR CARRYING OUT THE INVENTION

The embodiments of the present invention will hereinafter be described in detail.

[Phosphorescent agent]

The phosphorescent agent according to the present invention comprises a polymer (hereinafter referred to as "specific polymer") having in its molecule a structural unit represented by the above general formula (1). The specific polymer may be composed of a structural unit represented by the above general formula (1) only, or may also be the one having an additional structural unit or units. In the case where the specific polymer has the additional structural unit, the polymer may have the structural unit represented by the above general formula (1) at a terminal or in main chain, or both at a terminal and in main chain of the molecule.

In the above general formula (1), M is a metal atom having a valence of 2 to 4. The metal atom thereof may preferably be a transition metal atom in group 7 through group 10 of the periodic table. Specific examples thereof include Pd, Pt, Rh, Ir, Ru, Os and Re. Among these, Ir, Os or Pt is preferable because it has a large work function.

Each of $R^1$ and $R^2$ is a hydrogen atom, a halogen atom or a monovalent organic group selected from an alkyl group, an aryl group and a heterocycle group, and $R^1$ and $R^2$ may be either the same or different.

Specific examples of halogen atom include chlorine atom, fluorine atom and the like.

The alkyl group and the cycloalkyl group may preferably have 1 to 12 carbon atoms. Specific examples of the alkyl group include, methyl group, ethyl group, propyl group, t-butyl group, hexyl group, octyl group, dodecyl group and the like, and the group may have a side chain or chains.

The aryl group and the heterocycle group may preferably have 4 to 14 carbon atoms. Specific examples of the aryl group include phenyl group, naphthyl group, anthracenyl group, biphenyl group and the like. Specific examples of the heterocycle group include thienyl group, pyrrolyl group, furyl group, pyridyl group, pyrimidinyl group, triazinyl group, oxazolyl group, oxaziazolyl group, tetrahydrofuryl group, tetrahydrothiofuryl group and the like.

$X^1$ is a phenylene group or a oxycarbonyl group, $X^2$ is an alkylene group, and the alkylene group may preferably have 1 to 8 carbon atoms.

L is an organic ligand, and the organic ligand is formed with an organic compound having coordinating ability

to the metal atom M in the general formula (1). The number p of the organic ligand is an integer of 1 to 3, and is suitably selected in accordance with the number of valence of the metal atom concerned and a stable coordination number of a neutral complex with the metal atom. More specifically, the number p of the organic ligand is selected so that the number of outer most shell electrons in the metal atom is to be 16 or 18.

As specific examples of the organic compound forming the organic ligand include;
an organic compound forming a neutral unidentate organic ligand such as, trialkylamines, triarylamines, pyridine, quinoline, oxazole, trialkylphosphines and triarylphosphines; an organic compound forming a unidentate organic ligand such as alkoxides such as methoxides, t-butoxides and phenoxides and carboxylates such as acetates and trifluoroacetates; an organic compound forming a multidentate organic ligand include, acetylacetone, hexafluoroacetylacetone and β-diketones such as 5,5-dimethyl-2,4-hexadione, diamines such as ethylenediamine and dipyridyl,9-hydroxyquinoline, picolinic acid and salicylic acid; and phenylpyridine compounds represented by the following general formula (3). These compounds may be used either alone or in combination of two or more.

General formula (3)

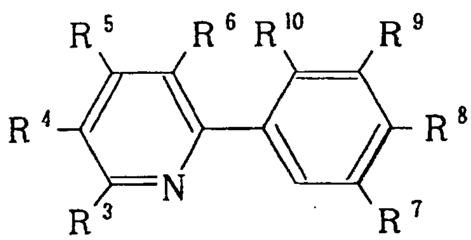

[In the general formula (3), each of $R^3$ through $R^{10}$ represents a hydrogen atom, a halogen atom or a monovalent organic group independently, and among $R^3$ through $R^{10}$, a ring may be formed by adjacent two groups bonded to each other.]

Among the above-mentioned organic compounds, are preferred β-diketones and phenylpyridine compounds represented by the above general formula (3), in that chelate can be easily formed. Moreover, the phenylpyridine compound represented by the above general formula (3) is particularly preferable, since dehydrogenation of hydrogen atom at ortho-position of the 2-substituted phenyl group to pyridine ring may easily occur, and the dehydrogenated carbon atom in the 2-substituted phenyl group may form a σ-bond with the metal atom, as well as the nitrogen atom in the pyridine ring may act as an ortho-metallation type chelating agent to coordinate with the metal atom, so that a chemically stable phosphorescent agent can be obtained and the wavelength and strength of phosphorescence by the phosphorescent agent can be controlled.

As specific examples of the phenylpyridine compound represented by the general formula (3) include, 2-phenylpyridine, 2-biphenylpyridine, 2-(4-(2,6-dimethylphenyl)phenyl)pyridine, 2-phenyl-4-(N,N-dimethylamino)pyridine, 2-phenyl-4-pyrrolidinopyridine, 2-phenyl-4-(N,N-diphenylamino)pyridine, 2-phenyl-4-methylpyridine, 2-phenyl-4,6-dimethylpyridine, 2-(2-fluorophenyl)pyridine, 2-(2,4-difluorophenyl)pyridine, 2-(2,3,4-trifluorophenyl)pyridine, 2-(2,3,4,5-tetrafluorophenyl)pyridine, 2-phenyl-4-methylpyridine, 2-(2-fluorophenyl)-4-methylpyridine, 2-(2,4-difluorophenyl)-4-methylpyridine, 2-(2,3,4-trifluorophenyl)-4-methylpyridine, 2-(2-naphthyl)pyridine, 2-phenylquinoline, 2-benzoylpyridine, 7,8-benzoquinoline, 9-anthranilpyridine, 2-(2-fluorenyl)pyridine, 2-(2-(9,10-dimethyl)fluorenyl)pyridine, 2-(2-(9,10-dihexyl)fluorenyl)pyridine, 2-(2-(9,10-dioctyl)fluorenyl)pyridine, and the like.

When the specific polymer making up the phosphorescent agent of the present invention comprises the structural unit represented by the above general formula (1) and the additional structural unit, as the additional structural unit may preferably be used those having a structural unit derived from a hole-transporting monomer, or those having both of the structural units derived from a hole-transporting monomer and from an electron-transporting monomer.

As the hole-transporting monomer, may preferably be used a carbazole derivative. As the carbazole derivative may be used α,β-unsaturated compound such as an alkenyl compound, a (meth)acrylic compound, or a styryl compound, having a substituted or unsubstituted carbazolyl group such as carbazolyl group, alkylcarbazolyl group, arylcarbazolyl group or the like. Specific examples thereof include, N-vinylcarbazole, N-(p-vinylphenyl)carbazole, 3,6-dimethyl-9-vinylcarbazole, 3,6-diethyl-9-vinylcarbazole, 3-methyl-9-vinylcarbazole, 3-ethyl-9-vinylcarbazole and the like.

As the electron-transporting monomer, an oxadiazole derivative may preferably be used. As the oxadiazole derivative may be used α,β-unsaturated compound such as an alkenyl compound, a (meth)acrylic compound, or a styryl compound, having a substituted or unsubstituted oxadiazolyl group such as oxadiazolyl group, alkyloxadiazolyl

group, aryloxadiazolyl group or the like. Specific examples thereof include, 2-(p-vinylphenyl)-5-β-naphthyl-1,3,4-oxadiazole, 2-(p-vinylphenyl)-5-biphenyl-1,3,4-oxadiazole, 2-phenyl-5-(p-vinylphenyl)-1,3,4-oxadiazole, 2-β-naphthyl-5-(4-vinylphenyl)-1,3,4-oxadiazole, 2-α-naphthyl-5-(4-vinylphenyl)-1,3,4-oxadiazole, 2-phenyl-5-(4-vinylphenyl)-oxadiazole, 2-phenyl-5-(4-vinyl-p-biphenyl)-1,3,4-oxadiazole, 2-(p-biphenyl)-5-(4-vinylphenyl)-1,3,4-oxadiazole, 2-(p-biphenyl)-5-(4-propenylphenyl)-1,3,4-oxadiazole, 2-t-butoxyphenyl-5-(4-(4-vinylphenyl)-p-biphenyl)-1,3,4-oxa diazole, or substituted compounds of these oxadiazole derivatives with an acryloyl or methacryloyl group.

A proportion of the structural unit represented by the general formula (1) in the specific polymer making up the phosphorescent agent according to the present invention, may preferably be 0.1 mol % or more, more preferably 1 mol% or more of all of structural units. If the proportion is too low, both of the luminance and the luminous efficiency tend to be low in some cases.

The specific polymer making up the phosphorescent agent of the present invention preferably has a weight average molecular weight of 500 to 1,000,000, particularly 5,000 to 500,000, in terms of polystyrene as measured by gel permeation chromatography (hereinafter referred to as "GPC"). If the weight average molecular weight is lower than 500, or higher than 1,000,000, an applicability of the after-mentioned luminescent composition becomes low, hence it is not preferable.

The specific polymer making up the phosphorescent agent of the present invention can be obtained by reacting the polymer (hereinafter referred to as "specific precursor polymer") having the structural unit represented by the above general formula (2) with an organic metal complex.

The specific precursor polymer can be obtained by polymerizing a monomer composition containing a compound represented by the following general formula (4), specifically, a monomer composition comprising the compound represented by the following general formula (4) only, a monomer composition comprising the compound represented by the following general formula (4) and a monomer of the above-mentioned carbazole derivative, or a monomer composition comprising the compound represented by the following general formula (4) and monomers of the above-mentioned carbazole derivative and the above-mentioned oxadiazole derivative.

General formula (4)

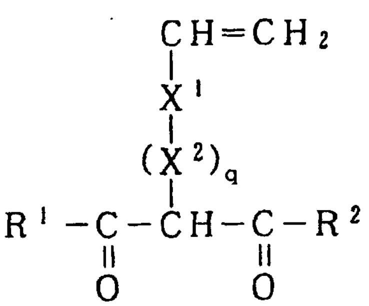

[In the general formula (4), each of $R^1$ and $R^2$ represents a hydrogen atom, a halogen atom, or a monovalent organic group selected from an alkyl group, a cycloalkyl group, an aryl group and a heterocycle group, $R^1$ and $R^2$ may be either the same or different. $X^1$ represents a phenylene group or a oxycarbonyl group, $X^2$ represents an alkylene group, and q is 0 or 1.]

As preferable specific examples of the compound represented by the general formula (4), may be mentioned such as 3-(p-vinylphenylmethylene)-pentane-2,4-dione as shown by the following formula (4-1),3-(vinylcarbonyloxy)-pentane-2,4-dione and compounds as shown by the following formulae (4-2) to (4-4).

Formula (4-1)

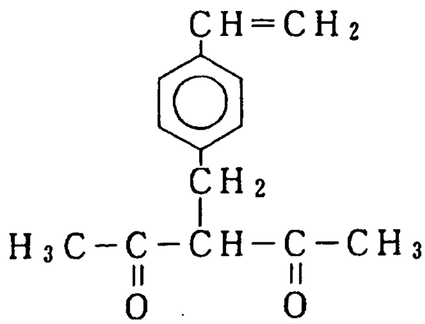

Formula (4-2)

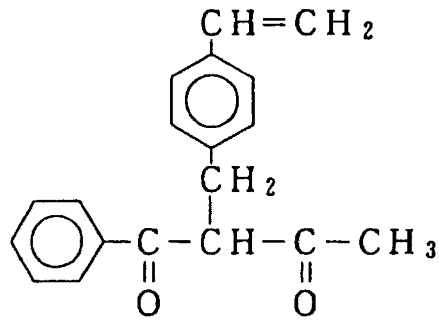

Formula (4-3)

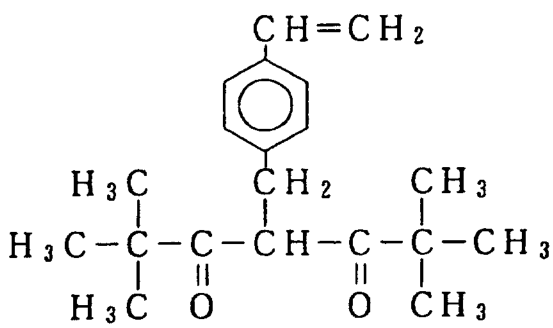

Formula (4-4)

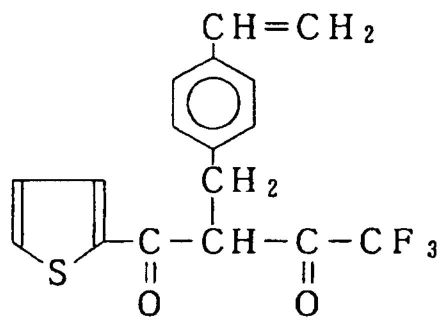

As polymerizing process for polymerizing the above monomer composition may be utilized a publicly known polymerization processes, for example, radical polymerization process, cationic polymerization process, anionic polymerization process, or living polymerization process thereof.

When the radical polymerization process is conducted, as a radical polymerization catalyst, may be used a catalyst such as azobisisobutyronitrile, azobis-1-acetoxy-1-phenylethane or the like, a catalyst composed of a combination of a peroxide and N-oxy radical such as 4-methylsulfonyloxy-2,2',6,6'-tetramethyl-1-piperidine-N-oxide, 3,3,5,5-tetramethyl-1-pyrroline-N-oxide or 4-oxo-2,2',6,6'-tetramethyl-1-piperidine-N-oxide, or a sulfide catalyst. A proportion of such a radical polymerization catalyst used is 0.0001 to 0.5 mol per 1 mol of the whole monomers.

As a solvent for polymerization, may be used amide solvents such as dimethylformamide, dimethylacetamide and N-methylpyrrolidone; hydrocarbon solvents such as benzene, toluene, xylene, hexane and cyclohexane; esters such as γ-butyrolactone and ethyl lactate; or ketone solvents such as cyclohexylbenzophenone and cyclohexanone.

The reaction temperature is, for example, 60 to 200°C.

When the cationic polymerization process is conducted, as a cationic polymerization catalyst, may be used a catalyst such as $HI\text{-}ZnI_2$, $I_2$ or $I_2\text{-}HI$. Besides, a catalyst composed of a combination of a Lewis acid and a base such as a metal halide-ether complex may also be used. A proportion of such cationic polymerization catalyst used is 0.0001 to 0. 5 mol per 1 mol of the whole monomers.

As a solvent for polymerization, may be used a halogenated hydrocarbon typified by methylene chloride or chlorobenzene, an ether solvent such as dibutyl ether, diphenyl ether, dioxane or tetrahydrofuran, or a high-polar solvent such as acetonitrile or nitrobenzene.

The reaction temperature is, for example, -150 to 50°C.

When the anionic polymerization process is conducted, as an anionic polymerization catalyst, may be used an alkali metal compound such as naphthalenepotassium or alkyllithium, an alkaline earth metal compound such as ate-complex of barium or aluminum. A proportion of such anionic polymerization catalyst used is 0.0001 to 0.5 mol per 1 mol of the whole monomers.

As a solvent for polymerization, may be used an aromatic hydrocarbon such as toluene or benzene, an aliphatic hydrocarbon such as hexane or heptane, an ether compound such as tetrahydrofuran.

The reaction temperature is, for example, 0 to 100°C.

In the case where the specific precursor polymer comprises the structural unit represented by the above general formula (2) and the additional structural unit, said specific precursor polymer can be a random copolymer or block copolymer. The block copolymer can be produced by preparing a polymer comprising the structural unit represented by the above general formula (2) and a polymer comprising the additional structural unit, in advance, and then combining these polymers.

As an organic metal complex used for obtaining the specific polymer, is preferably used a compound represented by the following general formula (5).

General formula (5) $M_x L_y Q_z$

[In the general formula (5), M represents a metal atom having a valence of 2 to 4, L represents an organic ligand and Q represents a hydrogen atom, a halogen atom or a ligand formed from an alkyl group, an alkoxy group or a carboxyl compound. x is an integer of 1 to 4, y is an integer of 0 to 8, and z is an integer of 0 to 8 with the proviso that y + z = 2 to 16.]

In the general formula (5), M representing a metal atom having a valence of 2 to 4 and L representing an organic ligand are corresponding to M and L in the above general formula (1), respectively. Specific examples of the carbonyl compounds include acetylacetone and the like.

In the general formula (5), Ir, Os and Pt are preferable examples for M, a phenylpyridine compound represented by the above general formula (3) is preferable example for L, and a halogen atom such as chlorine atom is preferable example for Q.

Specific examples of the compounds represented by the general formula (5) include, chlorobis(2-phenylpyridine)iridium or dimmer thereof, chlorobis(2-{p-(2,6-xylyl)phenyl}pyridine)iridium or dimmer thereof, chlorobis(2-(2,4-difluoro)phenyl-4-mehtylpyridine)iridium or dimmer thereof, chlorobis(2-phenylquinoline)iridium or dimmer thereof, chlorobis(2-phenylpyridine)osmium or dimmer thereof, chlorobis(2-{p-(2,6-xylyl)phenyl}pyridine)osmium or dimmer thereof, chlorobis(2-(2,4-difluoro)phenyl-4-mehtylpyridine)osmium or dimmer thereof, chlorobis(2-phenylquinoline)osmium or dimmer thereof, chlorobis(2-phenylpyridine)platinum or dimmer thereof, chlorobis (2-{p-(2,6-xylyl)phenyl}pyridine) platinum or dimmer thereof, chlorobis(2-(2,4-difluoro)phenyl-4-mehtylpyridine)platinum or dimmer thereof, chlorobis (2-phenylquinoline)platinum or dimmer thereof, and the like.

Among the organic metal complexes represented by the general formula (5), an organic metal complex in which M is Ir, L is an organic ligand comprised of the phenylpyridine compound represented by the above general formula (3) and Q is a chlorine atom and x is 2, y is 4 and z is 2, for example, can be obtained by reacting iridium trioxide with the phenylpyridine compound represented by the above general formula (3) in a suitable reaction solvent.

As a reaction solvent, may be used a polar solvent such as glycerin, ethylene glycol derivative or propylene glycol derivative, or a mixture of the polar solvent with water. Specific examples of ethylene glycol include ethylene glycol monomethylether, ethylene glycol monoethylether, ethylene glycol monobutoxyether and the like.

A proportion of the reaction solvent used is usually 100 to 10,000 weight parts per total 100 weight parts of iridium trioxide and the phenylpyridine compound represented by the general formula (3).

A proportion of iridium trioxide and the phenylpyridine compound represented by the general formula (3) used may preferably be 1:2 to 1:10 in terms of molar ratio.

The reaction temperature is, for example, 30 to 200°C, and the reaction time is 2 to 48 hours.

The reaction of the specific precursor polymer with the organic metal complex is preferably conducted in the suitable organic solvent under an inert gas atmosphere.

As the inert gas, may be used argon gas, nitrogen gas or the like.

As the organic solvent, may be used an organic compound having boiling point of 50 to 300°C under atmospheric pressure, and specific examples include tetrahydrofuran, dioxane, dimethylformamide, toluene, ethylene glycol monoethylether and the like.

The reaction conditions of the reaction temperature is 0 to 300°C, for example, and the reaction time is 1 to 48 hours, for example.

A proportion of the organic metal complex used is preferably 0.1 to 100 weight parts per 100 weight parts of the precursor polymer. If the proportion of the organic metal complex is too low, the reaction efficiency of the specific precursor polymer with the organic metal complex tends to become low. On the other hand, if the proportion of the organic metal complex is too high, uniformity of the respective component in the reaction system tends to become low.

A proportion of the organic solvent used is preferably 1 to 50 weight % in terms of solid concentration. If the proportion is 1 weight % or less, the reaction efficiency of the specific precursor polymer with the organic metal complex tends to become low. On the other hand, if the proportion exceeds 50 weight %, solid content tends to separate out. It is hence not preferable such a lower or higher proportion.

The phosphorescent agent thus obtained emits phosphorescence having a peak wavelength within a range of 440 to 700nm for example, therefore, it is suitable for a material of the luminescent layer of the organic electroluminescence device.
According to the above phosphorescent agent, since the phosphorescent agent itself is formed by polymer, it is easily able to form a thin film by the wet method such as printing method or ink-jet method, and further, an organic electroluminescence device having high luminance can be obtained, as shown in the after-mentioned examples.

<Luminescent composition>

The luminescent composition of the present invention is formed of the above phosphorescent agent dissolved in an organic solvent.
As the organic solvent, may be used any of a various kinds of organic solvents so far as it can dissolve the phosphorescent agent used therein. Specific examples thereof include, alcohols such as butanol, octanol, ethylene glycol, propylene glycol, ethylene glycol monomethyl ether, propylene glycol monomethyl ether, ethylene glycol monoethyl ether, propylene glycol monoethyl ether, ethylene glycol monobutyl ether and propylene glycol monobutyl ether; aromatic hydrocarbons such as toluene, xylene, cyclohexylbenzene and mesitylene; esters such as ethyl acetate, butyl acetate, ethyl lactate, ethoxypropylene glycol acetate, propylene glycol monomethyl acetate and γ-butyrolactone; amides such as N-methylpyrrolidone, formamide, dimethylformamide and dimethylacetoamide; ethers such as ethylene glycol dimethyl ether, diethylene glycol dimethyl ether, tetrahydrofuran and 1,4-dioxane; ketones such as cyclohexanone, methyl amyl ketone and methyl isobutyl ketone.
Among these, may be preferably used aromatic hydrocarbons, amides, ethers and ketones, and particularly preferred are ethyl lactate, propylene glycol monomethyl ether, propylene glycol monomethyl acetate, cyclohexanone, cyclohexylbenzene, mesitylene or the like.
A proportion of the organic solvent used is suitably selected according to the kinds of the phosphorescent agent and the like as used, however, it is generally selected within a range of 0.05 to 10 weight % in terms of solid concentration.
The luminescent composition according to the present invention may contain a polymer having a hole-transporting ability, for example, other than the above phosphorescent agent. As such polymer having the hole-transporting ability may be used a copolymer of the carbazole derivative as above-mentioned and the oxadiazole derivative as above-mentioned.
Using the luminescent composition according to the present invention, a luminescent layer of an organic electroluminescence device can be formed by steps of applying the luminescent composition on a surface of a substrate on which a luminescent layer is to be formed, and conducting removal treatment for removing the organic solvent to the resultant coated film.
As the means for applying the luminescent composition, may be used, for example, spin coating method, dipping method, roll coating method, ink-jet method, printing method or the like.

<Organic electroluminescence device>

FIG.1 is a cross sectional view for explanation showing a structure in an example of an organic electroluminescence device (hereinafter also referred to as "organic EL device") having a luminescent layer formed of the luminescent composition according to the present invention.
According to the organic EL device, an anode layer 2 is provided on a surface of a transparent substrate 1, a hole-transporting layer 3 is provided on the anode layer 2, a luminescent layer 5 is provided on the hole-transporting layer 3, an electron-injecting layer 6 is provided on the luminescent layer 5, and a cathode layer 7 is provided on the electron-injecting layer 6. The anode layer 2 and the cathode layer 7 are electrically connected to a direct current power supply 8.
In the above organic EL device, as the transparent substrate 1, may be used a glass substrate, a transparent resin substrate or a quartz glass substrate.
The anode layer 2 is also referred to as a hole-injecting electrode layer, and as a material making up the anode layer 2, may preferably be employed one having a high work function at least 4 eV, for example. The term "work function" as used herein refers to the minimum size of work required for taking an electron out from a solid to vacuum state. As the anode layer 2, may be used, for example, an ITO (Indium Tin Oxide) film, a tin oxide ($SnO_2$) film, a copper oxide (CuO) film, a zinc oxide (ZnO) film and the like.
As the means for forming the anode layer 2, may be used vacuum deposition method, sputtering method or the like. A commercially available material comprises an ITO film for example is formed on a surface of a transparent substrate such as glass substrate may also be used.
The hole-transporting layer 3 is also referred to as a hole-injecting layer, and is provided for the purpose of

efficiently supplying holes to the luminescent layer 5, and has a function of receiving holes from the anode layer 2 and transporting them to the luminescent layer 5.

As a material making up the hole-transporting layer 3, may preferably be employed an aromatic polymer, particularly, PEDOT [a complex of polydioxythiophene with polystyrenesulfonate (Poly(3,4)-ethylenedioxythiophene-polystyrenesulfonate), commercially available as trade name: "Baytron", (product of Bayer AG)] is preferable. As the other materials, may be employed, such as, 1,1-bis(4-di-p-aminophenyl)cyclohexane, triphenylamine derivatives and carbazole derivatives.

The hole-transporting layer 3 may be formed by a dry method such as vacuum deposition method, or by a wet method of dissolving a hole-transporting material in a proper solvent, and then applying the resultant solution by means of spin-coating method, dipping method, ink-jet method, printing method or the like, and drying.

The thickness of the hole-transporting layer 3 is, for example, 10 to 200 nm.

The luminescent layer 5 has a function of combining electrons with holes to emit the combine energy thereof as a light. The luminescent layer 5 comprises the phosphorescent agent according to the present invention.

More specifically, the luminescent layer 5 can be formed by applying the luminescent composition by means of spin-coating method, dipping method, ink-jet method, printing method or the like, and drying.

The thickness of the luminescent layer 5 is, for example, 1 to 200 nm.

The electron-injecting layer 6 has a function of receiving electrons from the cathode layer 7 and transporting them to the luminescent layer 5. As a material for making up the electron-injecting layer 6, may preferably be employed bathophenanthroline material (BPCs), and as the other materials may also be employed such as lithium fluoride, magnesium fluoride, strontium oxide, anthraquinodimethane derivatives, diphenyl quinone derivatives, oxadiazole derivatives and perylenetetra carboxylic acid derivatives.

The electron-injecting layer 6 can be formed by a dry method such as vacuum deposition method, or by a wet method of dissolving an electron-injecting material in a proper solvent, and then applying the resultant solution by means of spin-coating method, dipping method, ink-jet method, printing method or the like, and drying.

The thickness of the electron-injecting layer 6 is, for example, 0.1 to 100 nm.

The cathode layer 7 is also referred to as an electron-injecting electrode layer, and as a material making up the cathode layer 7, may preferably be employed one having a low work function at most 4 eV, for example. Specific examples of the cathode layer 7 include metal films composed of aluminum, calcium, magnesium, indium or the like, or alloy films of these metals.

Such cathode layer 7 can be formed by means of vacuum deposition method, sputtering method or the like.

In the organic EL device having the above-mentioned structure, when direct current voltage is applied between the anode layer 2 and the cathode layer 7 by the direct current power supply 8, the luminescent layer 5 emits a light and the light radiates through the anode layer 2 and the transparent substrate 1.

According to the organic EL device having such a structure, since the luminescent layer 5 comprises the phosphorescent agent of the present invention, high luminance can be obtained, and moreover, the luminescent layer 5 can easily be formed by a wet method using the luminescent composition of the present invention.

In the phosphorescent agent of the present invention making up the luminescent layer 5, structures having luminescent faculty are distributed or dispersed over the luminescent agent in molecular order, and no self-vanishing by association or the like is occurred, thereby exhibiting high luminous efficiency as well as high durability.

In the organic EL device using the luminescent composition according to the present invention, no limitations are to be imposed on the structure as above, and a various of changes or modifications may be incorporated.

For example, a copper-phthalocyanine layer 4 can be formed between the hole-transporting layer 3 and the luminescent layer 5, as shown in the FIG.2.

The copper-phthalocyanine layer 4 lowers the energy barrier between the hole-transporting layer 3 and the luminescent layer 5, by being provided between the hole-transporting layer 3 and the luminescent layer 5, thereby, injection of holes to the luminescent layer 5 can be carried out more smoothly, and energy matching can be achieved easily between the hole-transporting layer 3 and the luminescent layer 5. Further, by providing of such copper-phthalocyanine layer 4, the organic EL device having a long lifetime of use, high luminous efficiency and high durability can be obtained.

Such copper-phthalocyanine layer 4 can be formed by a dry method such as vacuum deposition method or sputtering method, or by a wet method of applying a solution containing copper-phthalocyanine by means of spin-coating method, dipping method, ink-jet method, printing method or the like, and drying.

The thickness of the copper-phthalocyanine layer 4 is, for example, 0.5 to 50 nm.

The present invention will hereinafter be described specifically by the following examples. However, the present invention is not limited to these examples.

(1) Preparation of a specific precursor polymer:

<Preparation Example 1-1>

A nitrogen-substituted flask was charged with 1.93 g (10.0 mmol) of N-vinylcarbazole, 0.27 g (1.0 mmol) of 3-(p-vinylphenylmethylene)-pentane-2,4-dione represented by the following formula (i), 0.082 g of azobisisobutyronitrile and 10 ml of dimethylformamide anhydride, and the system was heated and stirred for 30 hours at 65°C. The resultant reaction liquid was then cooled and poured into a great amount of methanol to precipitate resultant product. After the product was washed and dried, thereby obtaining a white powder.

The product was a copolymer composed of 91 mol % of structural unit derived from N-vinylcarbazole and 9 mol % of structural unit derived from 3-(p-vinylphenylmethylene)-pentane-2,4-dione, and had a weight average molecular weight determined by gel permeation chromatography (GPC) of 37,000 in terms of polystyrene. The copolymer is called "Precursor polymer (1)".

Formula (i)

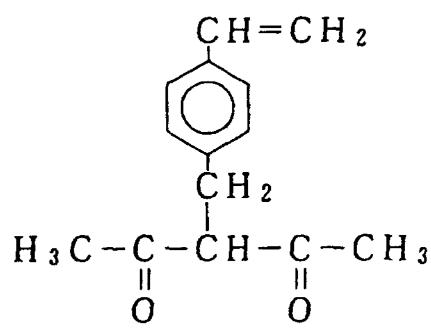

<Preparation Example 1-2>

According to the same manner as in the Preparation Example 1-1 except that 0.596 g (2 mmol) of 2-(p-vinylphenyl)-5-β-naphthyl-1,3,4-oxadiazole was additionally added as a monomer, a white or slightly pale yellowish powder was obtained.

The product thus obtained was a copolymer composed of 77 mol % of structural unit derived from N-vinylcarbazole, 7 mol % of structural unit derived from 3-(p-vinylphenylmethylene)-pentane-2,4-dione and 16 mol % of structural unit derived from 2-(p-vinylphenyl)-5-β-naphthyl-1,3,4-oxadiazole, and had a weight average molecular weight determined by gel permeation chromatography (GPC) of 32,000 in terms of polystyrene. The copolymer is called "Precursor polymer (2)".

<Preparation Example 1-3>

According to the same manner as in the Preparation Example 1-1 except that 0.466 g (1.44 mmol) of 2-(p-vinylphenyl)-5-biphenyl-1,3,4-oxadiazole was additionally added as a monomer, a white or pale yellowish powder was obtained.

The product thus obtained was a copolymer composed of 80 mol % of structural unit derived from N-vinylcarbazole, 8 mol % of structural unit derived from 3-(p-vinylphenylmethylene)-pentane-2,4-dione and 12 mol % of structural unit derived from 2-(p-vinylphenyl)-5-biphenyl-1,3,4-oxadiazole, and had a weight average molecular weight determined by the gel permeation chromatography (GPC) of 28,000 in terms of polystyrene. The copolymer is called "Precursor polymer (3)".

<Preparation Example 1-4>

According to the same manner as in the Preparation Example 1-1 except that 0.760 g (2 mmol) of 2-phenyl-5-(p-vinylphenyl)-1,3,4-oxadiazole was additionally added as a monomer, a white powder was obtained.

The product thus obtained was a copolymer composed of 78 mol % of structural unit derived from N-vinylcarbazole, 7 mol % of structural unit derived from 3-(p-vinylphenylmethylene)-pentane-2,4-dione and 15 mol % of structural unit derived from 2-phenyl-5-(p-vinylphenyl)-1,3,4-oxadiazole, and had a weight average molecular weight determined by the gel permeation chromatography (GPC) of 41,000 in terms of polystyrene. The copolymer is called "Precursor polymer (4)".

<Preparation Example 1-5>

According to the same manner as in the Preparation Example 1-4 except that 2.8 g (10.4 mmol) of N-(p-vinylphenyl) carbazole was used instead of N-vinylcarbazole, a light beige powder was obtained.

The product thus obtained was a copolymer composed of 78 mol % of structural unit derived from N-(p-vinylphenyl) carbazole, 7 mol % of structural unit derived from 3-(p-vinylphenylmethylene)-pentane-2,4-dione and 15 mol % of structural unit derived from 2-phenyl-5-(p-vinylphenyl)-1,3,4-oxadiazole, and had a weight average molecular weight determined by the gel permeation chromatography (GPC) of 13,000 in terms of polystyrene. The copolymer is called "Precursor polymer (5)".

(2) Preparation of Organic metal complex:

<Preparation Example 2-1>

Mixed were 2g of iridium trichloride (III) hydrate, 5.0 g of phenylpyridine, 120 g of ethoxyethanol and 40 g of purified water, and the mixture was heated and stirred for 10 hours at 115°C under nitrogen stream. The resultant reaction liquid was cooled and deposited product was separated by filtration and then vacuum-dried, thereby obtaining 3.8 g of yellow crystal. The product was a dimmer of chlorobis(2-phenylpyridine) iridium (III). The material is called "organic metal complex (1)".

<Preparation Example 2-2>

Mixed were 2g of iridium trichloride (III) hydrate, 3.5 g of 2-{p-(2,6-xylyl)phenyl}pyridine, 120 g of ethoxyethanol and 40g of purified water, and the mixture was heated and stirred for 24 hours at 115°C under nitrogen stream. The resultant reaction liquid was cooled and deposited product was separated by filtration and then vacuum-dried, thereby obtaining 3.8 g of yellow crystal. The product was a dimmer of chlorobis(2-{p-(2,6-xylyl)phenyl}pyridine)iridium (III). The material is called "organic metal complex (2)".

<Preparation Example 2-3>

Mixed were 2g of iridium trichloride (III) hydrate, 3.0 g of 2-(2,4-difluoro)phenyl-4-mehtylpyridine, 120 g of ethoxyethanol and 40g of purified water, and the mixture was heated and stirred for 24 hours at 115°C under nitrogen stream. The resultant reaction liquid was cooled and deposited product was separated by filtration and then vacuum-dried, thereby obtaining 4.8 g of yellow crystal. The product was a dimmer of chlorobis(2-(2,4-difluoro)phenyl-4-mehtylpyridine)iridium (III). The material is called "organic metal complex (3)".

<Preparation Example 2-4>

Mixed were 2g of iridium trichloride (III) hydrate, 3.0 g of 2-phenylquinoline, 120 g of ethoxyethanol and 40g of purified water, and the mixture was heated and stirred for 18 hours at 115°C under nitrogen stream. The resultant reaction liquid was cooled and deposited product was separated by filtration and then vacuum-dried, thereby obtaining 3.8 g of reddish-brown crystal. The product was a dimmer of chlorobis(2-phenylquinoline)iridium (III). The material is called "organic metal complex (4)".

<Example 1>

A solution composed of 2.0g of the Precursor polymer (1), 0.15 g of the organic metal complex (1), 0.1 g of sodium carbonate and 50 ml of hydrous tetrahydrofuran was stirred at room temperature for 1 hour under nitrogen stream, and then stirred for 16 hours at 80°C. Subsequently, the reaction solution was cooled and reprecipitation with methanol for purification was conducted, thereby obtaining a specific polymer composed of structural unit represented by the following formula (a-1) and structural unit (structural unit derived from N-vinylcarbazole) represented by the following formula (a-2) . The resultant specific polymer thus obtained was dissolved in chloroform, and the solution exhibited green phosphorescence spectrum. This specific polymer is called "phosphorescent agent (1)".

A luminescent composition was prepared by adding 5 parts by weight of the phosphorescent agent (1) to 95 parts by weight of cyclohexanone and dissolving. The composition is called "luminescent composition (1)".

Formula (a-1)

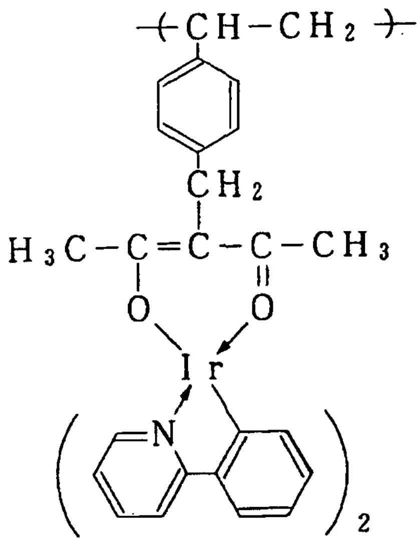

Formula (a-2)

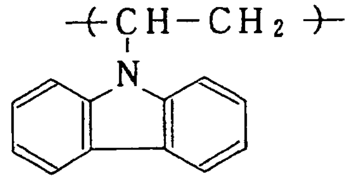

A glass substrate of 5 cm square on which an ITO film had been formed was provided, an aqueous dispersion of PEDOT (trade name: Baytron P8000, product of Bayer AG) of 2.75 % by weight was applied to the surface of the ITO film on the substrate, and the substrate thus obtained was subjected to a heat treatment at 150°C for 30 minutes, thereby forming an hole-transporting layer having a thickness of 65 nm.

The above luminescent composition (1) was then applied on the surface of the hole-transporting layer by a spin-coater and a heat treatment at 150°C for 10 minutes was conducted to form a luminescent layer having a thickness of 55 nm.

On the surface of the luminescent layer thus formed, bathophenanthroline and Cs were vacuum-deposited so as to give a molar ratio of 1:3 to form an electron-injecting layer having a thickness of 25 nm.

An aluminum film having a thickness of 100 nm was then formed in layer on the surface of the electron-injecting layer thus obtained, and then sealing with a glass material was conducted, thereby producing an organic EL device.

To the resultant organic EL device, applying 10V of direct current voltage between the ITO film for the anode layer and the aluminum film for the cathode layer to operate the organic EL device to emit light, and evaluated its emitting color and luminance. The results were that the emitting color was green and luminance was 25,000 cd/$m^2$.

<Example 2>

A solution composed of 2.0g of the Precursor polymer (2), 0.2 g of the organic metal complex (2), 0.1 g of sodium carbonate and 50 ml of hydrous tetrahydrofuran was stirred at room temperature for 1 hour under nitrogen stream, and then stirred for 18 hours at 50°C. Subsequently, the reaction solution was cooled and reprecipitation with methanol for purification was conducted, thereby obtaining a specific polymer composed of structural unit represented by the following formula (b-1), structural unit (structural unit derived from N-vinylcarbazole) represented by the following formula (b-2) and structural unit (structural unit derived from 2-(p-vinylphenyl)-5-β-naphthyl-1,3,4-oxdiazole) represented by the following formula (b-3). The resultant specific polymer thus obtained was dissolved in chloroform, and the solution exhibited green phosphorescence spectrum. This specific polymer is called "phosphorescent agent (2)".

A luminescent composition was prepared by adding 5 parts by weight of the phosphorescent agent (2) to 95 parts by weight of cyclohexanone and dissolving. The composition is called "luminescent composition (2)".

Formula (b-1)

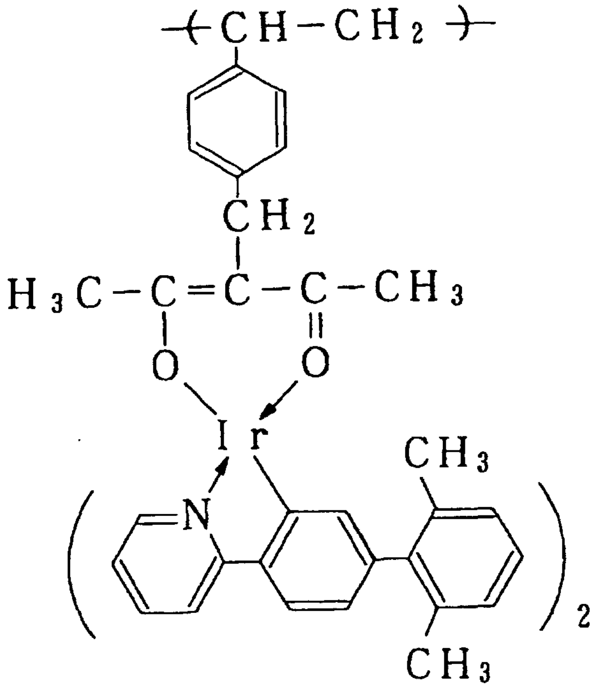

Formula (b-2)

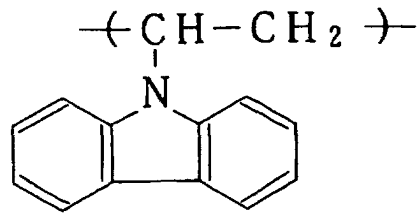

Formula (b-3)

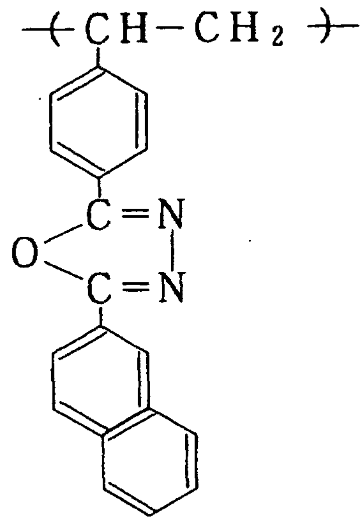

An organic EL device was produced in the same manner as Example 1 except that the luminescent composition (2) was used instead of the luminescent composition (1), and evaluated its emitting color and luminance. The results were that the emitting color was green and luminance was 35,000 cd/$m^2$.

<Example 3>

A solution composed of 2.0g of the Precursor polymer (3), 0.18 g of the organic metal complex (3), 0.1 g of sodium carbonate and 50 ml of hydrous tetrahydrofuran was subjected to reaction for 48 hours at 50°C under nitrogen stream. Subsequently, the reaction solution was cooled and reprecipitation with methanol for purification was conducted, thereby obtaining a specific polymer composed of structural unit represented by the following formula (c-1), structural unit (structural unit derived from N-vinylcarbazole) represented by the following formula (c-2) and structural unit (structural unit derived from 2-(p-vinylphenyl)-5-biphenyl-1,3,4-oxdiazole) represented by the following formula (c-3). The resultant specific polymer thus obtained was dissolved in chloroform, and the solution exhibited bluish green phosphorescence spectrum. This specific polymer is called "phosphorescent agent (3)".

A luminescent composition was prepared by adding 5 parts by weight of the phosphorescent agent (3) to 95 parts by weight of cyclohexanone and dissolving. The composition is called "luminescent composition (3)".

Formula (c-1)

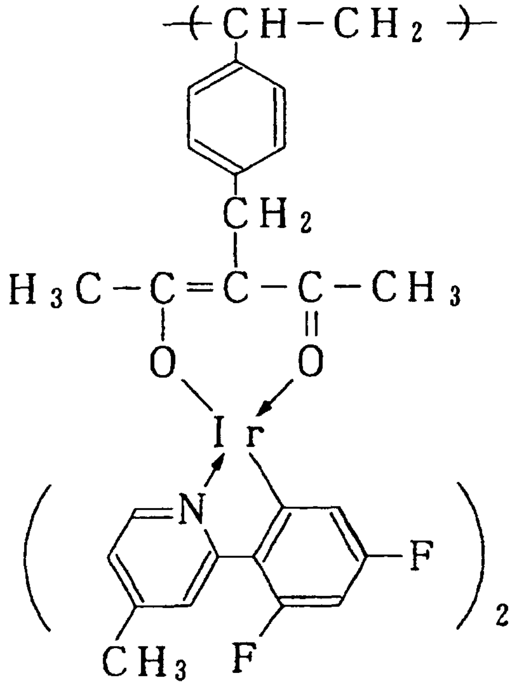

Formula (c-2)

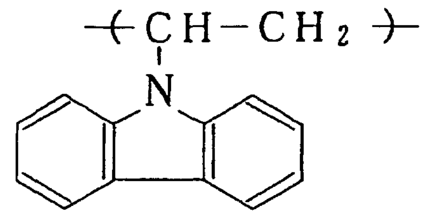

Formula (c-3)

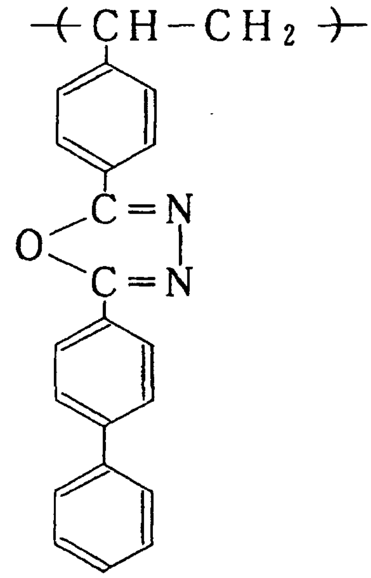

An organic EL device was produced in the same manner as Example 1 except that the luminescent composition (3) was used instead of the luminescent composition (1), and evaluated its emitting color and luminance. The results were that the emitting color was blue and luminance was 2,000 cd/$m^2$.

<Example 4>

A solution composed of 2.0g of the Precursor polymer (4), 0.18 g of the organic metal complex (4), 0.1 g of sodium carbonate and 50 ml of hydrous tetrahydrofuran was stirred for 6 hours at 80°C under nitrogen stream. Subsequently, the reaction solution was cooled and reprecipitation with methanol for purification was conducted, thereby obtaining a specific polymer composed of structural unit represented by the following formula (d-1), structural unit (structural unit derived from N-vinylcarbazole) represented by the following formula (d-2) and structural unit (structural unit derived from 2-phenyl-5-(p-vinylphenyl)-1,3,4-oxdiazole) represented by the following formula (d-3). The resultant specific polymer thus obtained was dissolved in chloroform, and the solution exhibited red phosphorescence spectrum. This specific polymer is called "phosphorescent agent (4)".

A luminescent composition was prepared by adding 5 parts by weight of the phosphorescent agent (4) to 95 parts by weight of cyclohexanone and dissolving. The composition is called "luminescent composition (4)".

Formula (d-1)

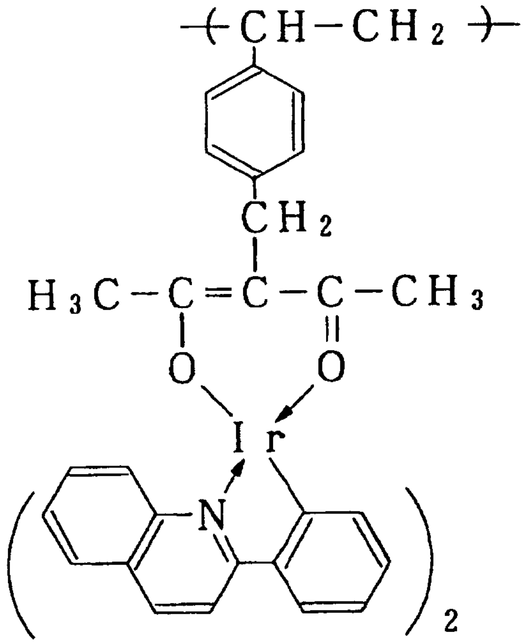

Formula (d-2)

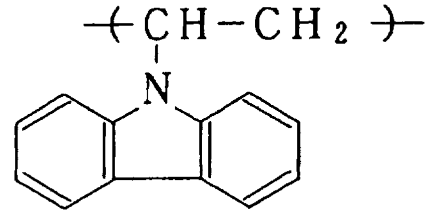

Formula (d-3)

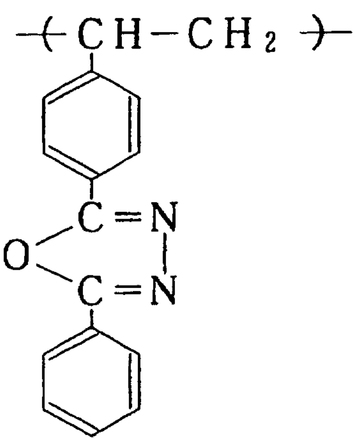

An organic EL device was produced in the same manner as Example 1 except that the luminescent composition (4) was used instead of the luminescent composition (1), and evaluated its emitting color and luminance. The results were that the emitting color was red and luminance was 13,000 cd/m$^2$.

<Example 5>

The processes were conducted as in the same manner as Example 2 except that the Precursor polymer (5) was used instead of the Precursor polymer (2), thereby obtaining a specific polymer composed of structural unit represented by the following formula (e-1), structural unit (structural unit derived from N-(p-vinylphenyl)carbazole) represented by the following formula (e-2) and structural unit (structural unit derived from 2-phenyl-5-(p-vinylphenyl)-1,3,4-oxdiazole) represented by the following formula (e-3). The resultant specific polymer thus obtained was dissolved in chloroform, and the solution exhibited green phosphorescence spectrum. This specific polymer is called "phosphorescent agent (5)".

A luminescent composition was prepared by adding 5 parts by weight of the phosphorescent agent (5) to 95 parts by weight of cyclohexanone and dissolving. The composition is called "luminescent composition (5)".

Formula (e-1)

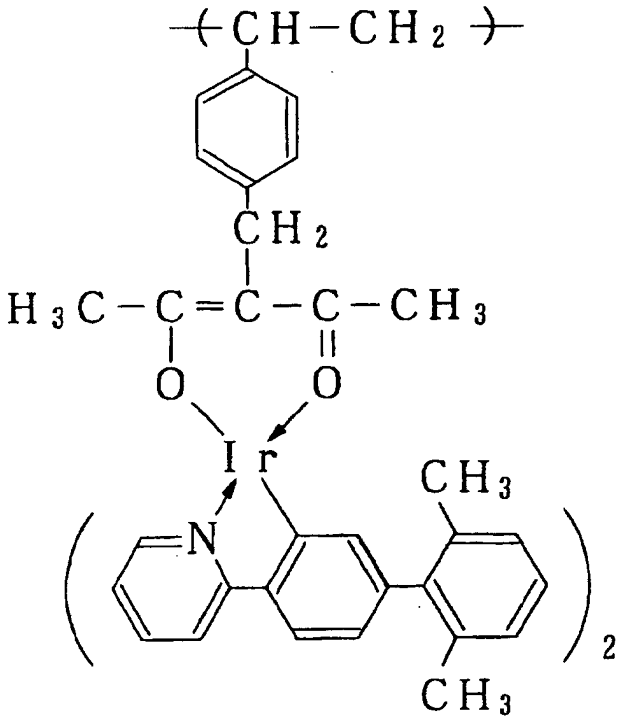

Formula (e-2)

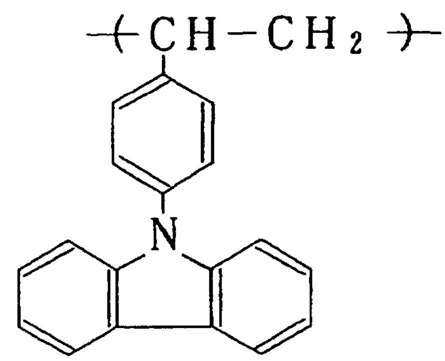

Formula (e-3)

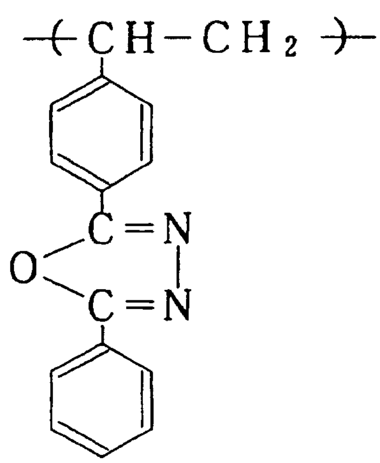

An organic EL device was produced in the same manner as Example 1 except that the luminescent composition (5) was used instead of the luminescent composition (1), and evaluated its emitting color and luminance. The results were that the emitting color was green and luminance was 12,000 cd/m$^2$.

<Comparative Example 1>

A comparative luminescent composition was prepared by dissolving 2 g of the Precursor polymer (1) and 0.15 g of the organic metal complex (1) in 40 g of cyclohexanone.

An organic EL device was produced in the same manner as Example 1 except that the comparative luminescent composition was used instead of the luminescent composition (1), and evaluated its emitting color and luminance. The results were that the emitting color was blue and luminance was 50 cd/m$^2$.

EFFECT OF THE INVENTION

According to the phosphorescent agent of the present invention, a thin film thereof can be formed easily by a wet method such as printing method or ink-jet method, and there can be provided an organic electroluminescence device having high luminance.

According to the production process of the phosphorescent agent of the present invention, the above phosphorescent agent can be produced advantageously.

According to the luminescent composition of the present invention, a thin film can be formed easily, and there can be provided an electroluminescence device having high luminance.

The organic electroluminescence device according to the present invention has a luminescent layer which

can be easily formed by a wet method such as printing method or ink-jet method, and performs high luminance.

According to the production process of the organic electroluminescence device of the present invention, a luminescent layer can be formed easily by a wet method such as printing method or ink-jet method, there can be produced an organic electroluminescence device performing high luminance.

## Claims

1. A phosphorescent agent comprising a polymer having in its molecule a structural unit represented by the following general formula (1).

General formula (1)

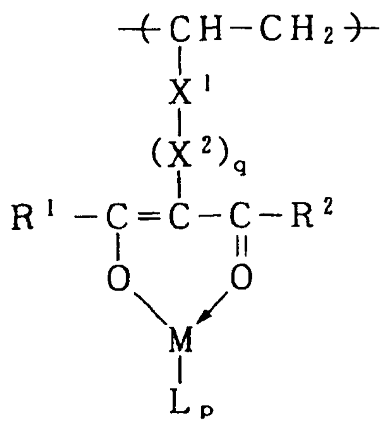

[In the general formula (1), M represents a metal atom having a valence of 2 to 4, each of $R^1$ and $R^2$ represents a hydrogen atom, a halogen atom or a monovalent organic group selected from an alkyl group, a cycloalkyl group, an aryl group and a heterocycle group and $R^1$ and $R^2$ may be either the same or different, $X^1$ represents a phenylene group or a carbonyloxy group, $X^2$ represents an alkylene group, L represents an organic ligand, p is an integer of 1 to 3, and q is 0 or 1.]

2. The phosphorescent agent according to claim 1, wherein the polymer contains a structural unit derived from a hole-transporting monomer in the molecule of the polymer.

3. The phosphorescent agent according to claim 2, wherein the polymer contains a structural unit derived from an electron-transporting monomer in the molecule of the polymer.

4. The phosphorescent agent according to claim 2 or 3, wherein the hole-transporting monomer is a carbazole compound having a vinyl group.

5. The phosphorescent agent according to claim 3, wherein the hole-transporting monomer is a carbazole compound having a vinyl group and the electron-transporting monomer is an oxadiazole compound having a vinyl group.

6. A production process of a phosphorescent agent comprising the step of synthesizing a polymer having in its molecule the structural unit represented by the general formula (1) according to claim 1, by reacting a polymer having in its molecule a structural unit represented by the following general formula (2) with an organic metal complex.

General formula (2)

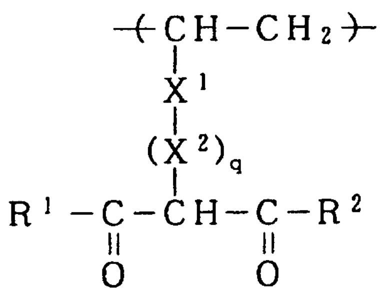

[In the general formula (2), each of $R^1$ and $R^2$ represents a hydrogen atom, a halogen atom or a monovalent organic group selected from an alkyl group, a cycloalkyl group, an aryl group and a heterocycle group and $R^1$ and $R^2$ may be either the same or different, $X^1$ represents a phenylene group or a carbonyloxy group, $X^2$ represents an alkylene group, and q is 0 or 1.]

**7.** A luminescent composition comprising the phosphorescent agent according to claim 1 dissolved in an organic solvent.

**8.** An organic electroluminescence device comprising a luminescent layer containing the phosphorescent agent according to claim 1.

**9.** A production process of an organic electroluminescence device comprising the steps of; applying the luminescent composition according to claim 7 on a surface of a substrate on which a luminescent layer is to be formed, and conducting removal treatment for removing an organic solvent to the resultant coated film to form a luminescent layer.

Fig. 1

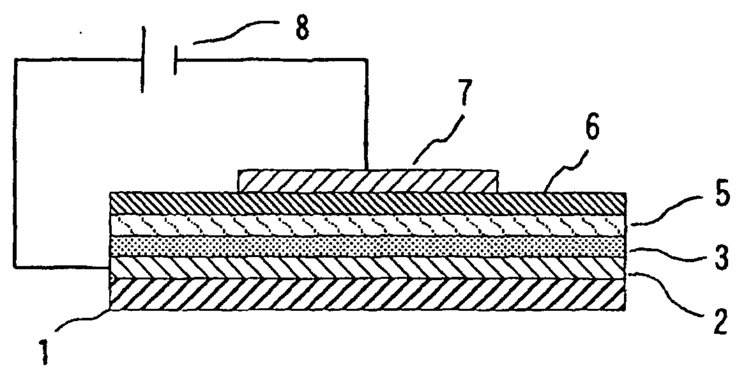


Fig. 2

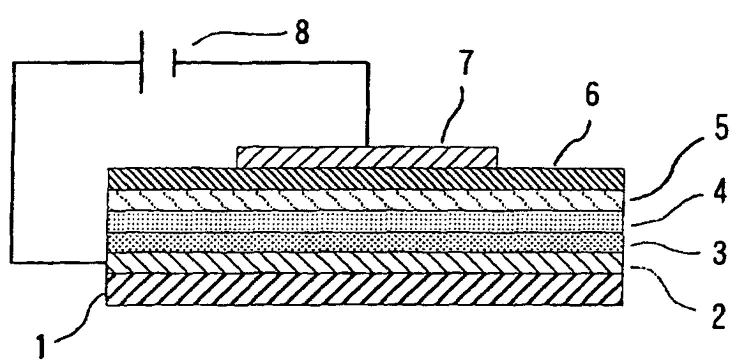

## INTERNATIONAL SEARCH REPORT

International application No.
PCT/JP03/08109

A. CLASSIFICATION OF SUBJECT MATTER
Int.Cl$^7$ C09K11/06, C08F30/04, H05B33/14, H05B33/10

According to International Patent Classification (IPC) or to both national classification and IPC

B. FIELDS SEARCHED

Minimum documentation searched (classification system followed by classification symbols)
Int.Cl$^7$ C09K11/06, C08F30/04, H05B33/14, H05B33/10

Documentation searched other than minimum documentation to the extent that such documents are included in the fields searched

Electronic data base consulted during the international search (name of data base and, where practicable, search terms used)
CA(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| P,X | WO 2003/001616 A2 (Shouwa Denko Kabushiki Kaisha), 03 January, 2003 (03.01.03), & JP 2003-113246 A | 1-9 |
| A | JP 2001-160490 A (Taiho Industries Co., Ltd.), 12 June, 2001 (12.06.01), Claims (Family: none) | 1-9 |
| A | JP 2000-243566 A (Sharp Corp.), 08 September, 2000 (08.09.00), Claims (Family: none) | 1-9 |
| A | JP 10-204426 A (Matsushita Electric Industrial Co., Ltd.), 04 August, 1998 (04.08.98), Claims (Family: none) | 1-9 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 24 September, 2003 (24.09.03) | 07 October, 2003 (07.10.03) |
| Name and mailing address of the ISA/ Japanese Patent Office | Authorized officer |
| Facsimile No. | Telephone No. |

Form PCT/ISA/210 (second sheet) (July 1998)